(19) Europäisches Patentamt
European Patent Office
Office européen des brevets

(11) EP 4 692 938 A1

(12) EUROPEAN PATENT APPLICATION
published in accordance with Art. 153(4) EPC

(43) Date of publication:
**11.02.2026 Bulletin 2026/07**

(21) Application number: **24780858.7**

(22) Date of filing: **29.03.2024**

(51) International Patent Classification (IPC):
***G03F 7/038*** *(2006.01)* ***C08G 69/02*** *(2006.01)*
***G03F 7/004*** *(2006.01)*

(52) Cooperative Patent Classification (CPC):
**C08G 69/02; G03F 7/004; G03F 7/038**

(86) International application number:
**PCT/JP2024/013181**

(87) International publication number:
**WO 2024/204763 (03.10.2024 Gazette 2024/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **29.03.2023 JP 2023054055**

(71) Applicant: **TAIYO HOLDINGS CO., LTD.**
**Saitama 355-0222 (JP)**

(72) Inventors:
- **INOUE, Go**
  **Hiki-gun, Saitama 355-0222 (JP)**
- **YUKIMORI, Daiki**
  **Hiki-gun, Saitama 355-0222 (JP)**
- **SHIBASAKI, Kaho**
  **Hiki-gun, Saitama 355-0222 (JP)**
- **OKUDA, Ayano**
  **Hiki-gun, Saitama 355-0222 (JP)**
- **ISHIKAWA, Nobuhiro**
  **Hiki-gun, Saitama 355-0222 (JP)**

(74) Representative: **Hoffmann Eitle**
**Patent- und Rechtsanwälte PartmbB**
**Arabellastraße 30**
**81925 München (DE)**

# (54) NEGATIVE PHOTOSENSITIVE RESIN COMPOSITION, DRY FILM, CURED PRODUCT, AND ELECTRONIC COMPONENT

(57) Provided is a negative photosensitive resin composition capable of providing a cured product having better elongation at break without impairing dissolution contrast (γ value) which is a measure of resolution of the negative photosensitive resin composition. Provided is a negative photosensitive resin composition containing a polyhydroxyamide compound (A), a photoacid generator (B), a crosslinking agent (C), and a phenol compound having two or more hydroxy groups (D), wherein the phenol compound having two or more hydroxy groups (D) has a molecular weight of 1,000 or less, and the content of the phenol compound having two or more hydroxy groups (D) is 0.01 parts by mass or more and 30 parts by mass or less with respect to 100 parts by mass of the solid content of the polyhydroxyamide compound (A).

EP 4 692 938 A1

## Description

### Technical Field

The present invention relates to a negative photosensitive resin composition, a dry film, a cured product, and an electronic component.

### Background Art

A photosensitive resin composition containing a polyhydroxyamide compound which is a polybenzoxazole precursor is widely used as an insulating film in various fields such as a semiconductor and an electronic component because the photosensitive resin composition exhibits excellent properties such as an insulation property, heat resistance, and mechanical strength.

For example, Patent Literature 1 discloses use of a photosensitive resin composition containing a specific polyamide derivative which is a photosensitive polybenzoxazole precursor, a compound that generates an acid by irradiation with radiation, and a compound capable of crosslinking the specific polyamide derivative. According to the disclosure of Patent Literature 1, an electronic component having excellent sensitivity, resolution, and heat resistance, having a pattern with a favorable shape, and having high reliability is provided.

Patent Literature 2 discloses use of a photosensitive resin composition containing a polybenzoxazole precursor, a photosensitive agent, a solvent, a crosslinking agent, and a specific heterocyclic compound. According to the disclosure of Patent Literature 2, a photosensitive resin composition that exhibits a high cyclodehydration ratio even when subjected to a heat treatment at 250°C or lower, and provides a patterned cured film having excellent chemical resistance and adhesion to a substrate under high temperature and high humidity conditions is provided.

### Citation List

#### Patent Literature

Patent Literature 1: JP 2001-125267 A
Patent Literature 2: WO 2012/172793 A

### Summary of Invention

#### Technical Problem

On the other hand, in an electronic component having an insulating film using such a photosensitive resin composition, higher integration of a semiconductor element is required according to demand for high performance and miniaturization. Therefore, in an insulating film used for a rewiring layer of a semiconductor element, an insulating film having high resolution and capable of further miniaturizing pattern formation is required.

On the other hand, the present inventors have conducted intensive studies focusing on dissolution contrast ($\gamma$ value) as a measure of resolution in order to enable finer patterning. However, the present inventors have found a new problem that when a pattern is miniaturized, cracks may be generated in a cured film even when a slight stress is applied, and an insulating film exhibiting better mechanical strength (elongation at break) is required for further miniaturization.

Therefore, an object of the present disclosure is to provide a negative photosensitive resin composition capable of providing a cured product having better elongation at break without impairing dissolution contrast ($\gamma$ value) which is a measure of resolution of the negative photosensitive resin composition. By better elongation at break of the cured product of the negative photosensitive resin composition, cracks are hardly generated in the cured product.

#### Solution to Problem

As a result of intensive studies, the present inventors have found that a negative photosensitive resin composition containing a polyhydroxyamide compound, a photoacid generator, a crosslinking agent, and a low molecular weight phenol compound having a specific content can solve the above problems, and have completed the present invention.

That is, according to an aspect of the present disclosure technique,

it is possible to provide a negative photosensitive resin composition containing a polyhydroxyamide compound (A), a photoacid generator (B), a crosslinking agent (C), and a phenol compound having two or more hydroxy groups (D), wherein

the phenol compound having two or more hydroxy groups (D) has a molecular weight of 1,000 or less, and

the content of the phenol compound having two or more hydroxy groups (D) is 0.01 parts by mass or more and 30 parts by mass or less with respect to 100 parts by mass of the solid content of the polyhydroxyamide compound (A).

A mass ratio between the content of the crosslinking agent (C) and the content of the phenol compound having two or more hydroxy groups (D) is preferably the crosslinking agent (C) : the phenol compound having two or more hydroxy groups (D) = 40 : 0.1 to 40 : 30.

According to another aspect of the present disclosure technique, it is possible to provide a dry film including a resin layer formed of the negative photosensitive resin composition.

According to another aspect of the present disclosure technique, it is possible to provide a cured product obtained by curing the negative photosensitive resin composition or the resin layer of the dry film.

According to another aspect of the present disclosure technique, it is possible to provide an electronic component including the cured product.

Advantageous Effects of Invention

According to the present disclosure technique, it is possible to provide a negative photosensitive resin composition capable of providing a cured product having better elongation at break without impairing dissolution contrast which is a measure of resolution of the negative photosensitive resin composition.

Description of Embodiments

Hereinafter, an embodiment of the present disclosure technique will be described in detail. Note that, in the present specification, the notation "p to q" in description of a numerical range represents p or more and q or less unless otherwise specified.

<<<Negative photosensitive resin composition>>>

A negative photosensitive resin composition of the present disclosure contains a polyhydroxyamide compound (A), a photoacid generator (B), a crosslinking agent (C), and a phenol compound having two or more hydroxy groups (D) (hereinafter, also simply abbreviated as a phenol compound (D)). Here, the phenol compound (D) has a molecular weight of 1,000 or less, and the content of the phenol compound (D) in the negative photosensitive resin composition is 0.01 parts by mass or more and 30 parts by mass or less when the solid content of the polyhydroxyamide compound (A) is 100 parts by mass. Such a negative photosensitive resin composition can provide a cured product having better elongation at break without impairing dissolution contrast of the negative photosensitive resin composition.

Hereinafter, the negative photosensitive resin composition of the present disclosure will be described in detail.

<<(A) Polyhydroxyamide compound>>

The polyhydroxyamide compound (A) has a plurality of hydroxy groups and a plurality of amide bonds in a molecular structure thereof. The polyhydroxyamide compound (A) is not particularly limited as long as the effect of the present disclosure technique is not impaired, but the polyhydroxyamide compound (A) preferably contains a structural unit represented by the formula (1) from a viewpoint of resolution of the negative photosensitive resin composition and insulation reliability of a cured product thereof.

[Chemical Formula 1]

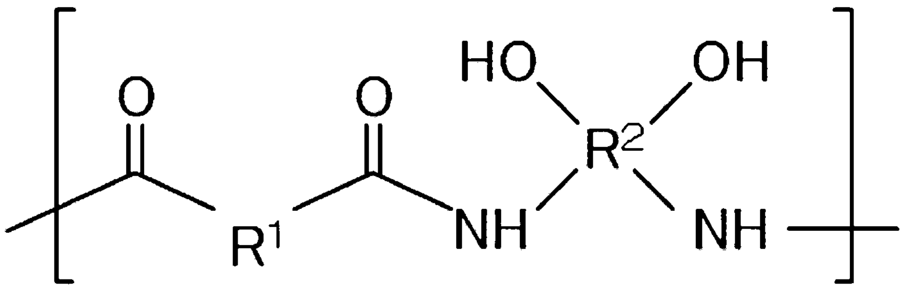

(1)

(In the formula, $R^1$ is a divalent organic group, and $R^2$ is a tetravalent organic group.)

$R^1$ in the formula (1) is not particularly limited as long as it is a divalent organic group, and examples thereof include an alkylene group, a cycloalkylene group, an arylene group, an alkyl ether group, a ketone group, and an ester group. Among these, a divalent aromatic hydrocarbon group having a skeleton such as benzene, naphthalene, perylene, biphenyl, diphenyl ether, diphenyl sulfone, diphenyl propane, diphenyl hexafluoropropane, or benzophenone, or a divalent aliphatic hydrocarbon group having a skeleton such as butane or cyclobutane is preferable. The carbon number of $R^1$ is preferably 4 to 30, and phenyl, biphenyl, diphenyl ether, and diphenyl hexafluoropropane are preferable from a viewpoint of resolution of the negative photosensitive resin composition and insulation reliability of a cured product thereof. Note that two or more of the organic groups exemplified above as $R^1$ can be contained in a molecule of the polyhydroxyamide compound (A).

$R^2$ in the formula (1) is not particularly limited as long as it is a tetravalent organic group, but is preferably a tetravalent aromatic hydrocarbon group having a skeleton such as diphenyl, diphenyl ether, diphenyl thioether, benzophenone, diphenyl methane, diphenyl propane, diphenyl hexafluoropropane, diphenyl sulfoxide, diphenyl sulfone, biphenyl, or benzene, and more preferably an organic group having a structure represented by the following formula (2).

[Chemical Formula 2]

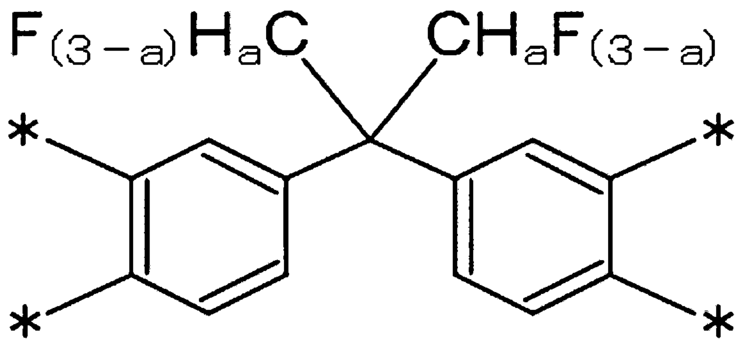

(2)

(In the formula, a is an integer of 0 to 3, and * indicates bonding.)

The polyhydroxyamide compound (A) preferably has a carboxyl group or a hydroxy group at a terminal thereof, and particularly preferably has a hydroxy group. According to this, since solubility in a developer is improved and reactivity between the polyhydroxyamide compound (A) and the crosslinking agent (C) described later is improved, resolution of the negative photosensitive resin composition can be further improved.

The polyhydroxyamide compound (A) has a weight average molecular weight (Mw) of preferably 2,000 to 20,000, more preferably 2,000 to 15,000, still more preferably 3,000 to 15,000, particularly preferably 4,000 to 10,000.

The polyhydroxyamide compound (A) has a number average molecular weight (Mn) of preferably 1,000 to 10,000, more preferably 1,500 to 6,000.

The polyhydroxyamide compound (A) has a molecular weight dispersion degree (PDI) of preferably 1.5 to 4.0, more preferably 1.5 to 3.5.

When the weight average molecular weight (Mw), the number average molecular weight (Mn), and the molecular weight dispersion degree (PDI) of the polyhydroxyamide compound (A) are in such ranges, solubility in a developer in an unexposed portion and reaction with the crosslinking agent (C) in an exposed portion are in a suitable balance, and a negative photosensitive resin composition having better resolution can be obtained.

In the present specification, the weight average molecular weight and the number average molecular weight are

numerical values measured by gel permeation chromatography (GPC) and converted in terms of standard polystyrene.

In the present specification, the molecular weight dispersion degree (PDI) is calculated by the following formula (Z).

$$PDI = Mw/Mn \cdots (Z)$$

A hydroxy group equivalent of the polyhydroxyamide compound (A) is not particularly limited, and can be, for example, 100 to 400 g/eq, preferably 150 to 350 g/eq, and more preferably 200 to 300 g/eq.

<<(B) Photoacid generator>>

The photoacid generator (B) is not particularly limited as long as it is a compound that generates an acid by irradiation with light such as an ultraviolet ray or visible light, and examples thereof include a naphthoquinone diazide compound, a nitrobenzyl ester, an aromatic N-oxyimide sulfonate, an aromatic sulfamide, a benzoquinone diazosulfonic acid ester, a naphthalimide compound, and an oxime sulfonate compound. These can be used singly or in combination of two or more thereof at any ratio.

The photoacid generator (B) is preferably an oxime sulfonate compound, and more preferably one having a structure of the following formula (3) from a viewpoint of further improving resolution of the negative photosensitive resin composition and insulation reliability of a cured product thereof.

[Chemical Formula 3]

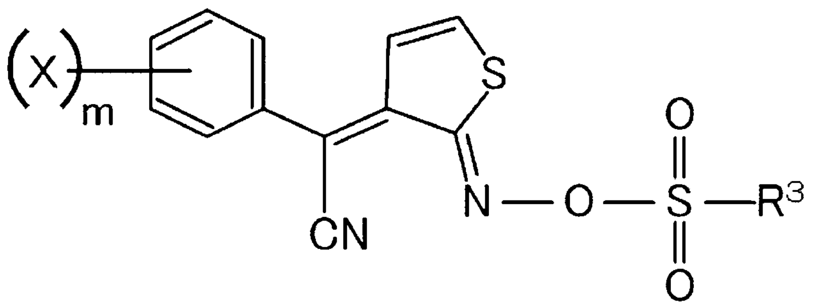

(3)

(In the formula, X is a monovalent organic group, m is an integer of 0 to 3, and $R^3$ is a monovalent organic group.)

X in the formula (3) is not particularly limited as long as it is a monovalent organic group, and can be, for example, a hydrocarbon group (for example, an alkyl group, an alkenyl group, an alkynyl group, an aryl group, or the like) or a halogen atom.

The hydrocarbon group may have a substituent, and can have a linear, branched, or cyclic structure. As the hydrocarbon group, a linear or branched hydrocarbon group having 1 to 4 carbon atoms is preferably used.

As the halogen atom, a chlorine atom or a fluorine atom is preferably used.

m in the formula (3) represents an integer of 0 to 3, and is preferably 0 or 1. When m is 2 or 3, a plurality of Xs may be the same as or different from each other.

$R^3$ in the formula (3) is not particularly limited as long as it is a monovalent organic group, and can be, for example, a hydrogen atom, a hydrocarbon group, an organic group containing a ketone group, or a halogen atom. The hydrocarbon group (for example, an alkyl group, an alkenyl group, an alkynyl group, or an aryl group) may have no substituent or may have a halogen atom as a substituent.

The hydrocarbon group is preferably a linear, branched, or cyclic hydrocarbon group having 1 to 20 carbon atoms, and more preferably a linear, branched, or cyclic hydrocarbon group having 1 to 10 carbon atoms.

As the halogen atom, a chlorine atom or a fluorine atom is preferably used.

Examples of commercially available oxime sulfonate compounds include Irgacure PAG103, Irgacure PAG108, Irgacure PAG121, and Irgacure PAG203 manufactured by BASF SE.

<<(C) Crosslinking agent>>

The crosslinking agent (C) is not particularly limited as long as it causes a crosslinking reaction with a hydroxy group or the like contained in the polyhydroxyamide compound (A). Examples of the crosslinking agent (C) include a

crosslinking agent having a cyclic ether group such as an epoxy group, a crosslinking agent having a cyclic thioether group such as an episulfide group, a crosslinking agent having an alcoholic hydroxy group in which a hydroxy group is bonded to an alkylene group having 1 to 12 carbon atoms such as a methylol group, a compound having an ether bond such as an alkoxymethyl group, a crosslinking agent having a triazine ring structure, and an urea-based crosslinking agent, and a crosslinking agent having an alcoholic hydroxy group in which a hydroxy group is bonded to an alkylene group having 1 to 12 carbon atoms such as a methylol group or a compound having an ether bond such as an alkoxymethyl group is preferable, and a crosslinking agent containing a plurality of methylol groups or a compound containing a plurality of methoxymethyl groups can be more preferably used. These functional groups cause a crosslinking reaction with a hydroxy group or the like contained in the polyhydroxyamide compound (A) or the like by heating using an acid generated from the photoacid generator (B) as an active species, and thus negative photolithography (pattern formation) is implemented by exposure, post exposure bake (PEB), and a development treatment. In addition, by further performing heating after the pattern formation, a curing reaction of the negative photosensitive resin composition proceeds, and excellent properties are exhibited as a cured product.

In addition, the crosslinking agent (C) desirably contains a heterocyclic ring from a viewpoint of improving resolution of the negative photosensitive resin composition and insulation reliability of a cured product thereof. The heterocyclic ring is not particularly limited, and includes one or more heteroatoms such as boron, nitrogen, oxygen, phosphorus, sulfur, antimony, arsenic, bismuth, selenium, silicon, tellurium, and tin, and includes a 3-membered ring, a 4-membered ring, a 5-membered ring, a 6-membered ring, a 7-membered ring, or an 8-membered saturated or unsaturated ring. The heterocyclic ring is preferably a heterocyclic ring containing nitrogen, and more preferably a heterocyclic ring containing a plurality of nitrogen atoms from a viewpoint of resolution of the negative photosensitive resin composition and insulation reliability of a cured product thereof. Specifically, a compound having a triazine structure, such as hexamethylolmelamine or hexamethoxymethylmelamine, a compound having a guanamine structure, such as tetramethylolbenzoguanamine or tetramethoxymethylbenzoguanamine, a compound having a glycoluril structure, such as tetramethylolglycoluril or tetramethoxyglycoluril, and a compound having an imidazolidinone structure, such as 1,3-bis(methoxymethyl)-2-imidazolidinone, are more preferable. Among these, a compound having a triazine structure containing a triazine ring and a compound having a guanamine structure can be preferably used.

<<(D) Phenol compound having two or more hydroxy groups>>

The phenol compound having two or more hydroxy groups (D) has a molecular weight of 1,000 or less. Since the phenol compound (D) causes a crosslinking reaction with the crosslinking agent (C), it is considered that a crosslinked portion is formed between molecular chains of the polyhydroxyamide compound (A) via the crosslinking agent (C). When the crosslinked portion between molecular chains of the polyhydroxyamide compound (A) is formed only by the crosslinking agent (C), it is presumed that since a molecular chain length of the crosslinked portion is short, a rigid structure having a high crosslinking density is formed, and elongation at break decreases. In this regard, in the present disclosure, it is presumed that since the phenol compound (D) forms a crosslinked portion between molecular chains of the polyhydroxyamide compound (A) via the crosslinking agent (C), a molecular chain length of the crosslinked portion is increased to decrease a crosslinking density, therefore a flexible structure is formed to improve elongation at break.

Furthermore, although a detailed mechanism is not clear, it is considered that by the fact that the phenol compound (D) has a molecular weight of 1,000 or less, a cured product having better elongation at break can be obtained without impairing dissolution contrast of the negative photosensitive resin composition.

Note that the phenol compound (D) is a compound different from the polyhydroxyamide compound (A), the photoacid generator (B), and the crosslinking agent (C).

In addition, in the present disclosure, the molecular weight of the phenol compound (D) is defined by a molecular weight calculated from a chemical structure thereof when the phenol compound (D) is a compound having no repeating unit structure, and is defined by a weight average molecular weight obtained by GPC measurement when the phenol compound (D) has a repeating unit structure.

The phenol compound (D) only needs to have at least one phenolic hydroxy group and another hydroxy group, the other hydroxy group is not particularly limited, and the phenol compound (D) may have a plurality of phenolic hydroxy groups. Examples of the phenol compound (D) include the following compounds.

Examples of a compound having a plurality of hydroxy groups in one aromatic ring include hydroquinone, catechol, resorcinol, hydroxyquinol, phloroglucinol, pyrogallol, and hexahydroxybenzene.

Examples of a compound having one phenolic hydroxy group and one hydroxy group other than the phenolic hydroxy group include: a compound having one phenolic hydroxy group and one hydroxy group other than the phenolic hydroxy group, such as 3-hydroxybenzyl alcohol, 4-hydroxybenzyl alcohol, 3-hydroxy-$\alpha$-methylbenzyl alcohol, 2-hydroxybenzyl alcohol, vanillyl alcohol, or 2-hydroxy-3-methoxybenzyl alcohol, and

examples of a compound having two phenolic hydroxy groups include:

an alkane such as bisphenol F, dimethyl bisphenol F, bis(3,5-dimethyl-4-hydroxyphenyl) methane, bis(2,3,5-trimethyl-4-hydroxyphenyl) methane, bis(3,5,6-trimethyl-4-hydroxyphenyl) methane, bis(2,3,5,6-tetramethyl-4-hydroxyphenyl) methane, bis(3,5-diethyl-4-hydroxyphenyl) methane, bis(3-t-butyl-4-hydroxyphenyl) methane, bis(3,5-dibutyl-4-hydroxyphenyl) methane, bis(3-methyl-4-hydroxy-5-phenylphenyl) methane, bis(3-methyl-4-hydroxy-5-benzylphenyl) methane, bis(3-phenyl-4-hydroxyphenyl) methane, 1,1-bis(4-hydroxyphenyl) ethane, 1,1-bis(3-methyl-4-hydroxyphenyl) ethane, 1,1-bis(3,5-dimethyl-4-hydroxyphenyl) ethane, 1,1-bis(2,3,5,6-tetramethyl-4-hydroxyphenyl) ethane, bisphenol A, 1,1-bis(4-hydroxyphenyl) propane, 2,2-bis(3-methyl-4-hydroxyphenyl) propane, 2,2-bis(3,5-dimethyl-4-hydroxyphenyl) propane, 2,2-bis(2,3,5,6-tetramethyl-4-hydroxyphenyl) propane, 2,2-bis(3-ethyl-4-hydroxyphenyl) propane, 2,2-bis(3,5-diethyl-4-hydroxyphenyl) propane, 2,2-bis(3-isopropyl-4-hydroxyphenyl) propane, 2,2-bis(3-t-butyl-4-hydroxyphenyl) propane, 2,2-bis(3-phenyl-4-hydroxyphenyl) propane, 2,2-bis(3,5-dibromo-4-hydroxyphenyl) propane, 2,2-bis(4-hydroxyphenyl) butane, or 2,2-bis(4-hydroxyphenyl) hexane;

a bis(hydroxyphenyl) phenylalkane such as bis(4-hydroxyphenyl) phenylmethane, bis(4-hydroxyphenyl) diphenylmethane, 1,1-bis(4-hydroxyphenyl)-1-phenylethane, 1,1-bis(4-hydroxyphenyl)-1-phenylpropane, or 2,2-bis(4-hydroxyphenyl)-1,3-diphenylpropane;

a bis(hydroxyphenyl) cycloalkane such as 1,1-bis(4-hydroxyphenyl) cyclopentane, 1,1-bis(4-hydroxyphenyl) cyclohexane, or 1,1-bis(3-methyl-4-hydroxyphenyl) cyclohexane;

a bis(hydroxyphenyl) sulfone such as bis(4-hydroxyphenyl) sulfone or bis(3,5-dimethyl-4-hydroxyphenyl) sulfone;

a bis(hydroxyphenyl) sulfide such as bis(4-hydroxyphenyl) sulfide or bis(3,5-dimethyl-4-hydroxyphenyl) sulfide;

a bis(hydroxyphenyl) ether such as bis(4-hydroxyphenyl) ether or bis(3,5-dimethyl-4-hydroxyphenyl) ether;

a bis(hydroxyphenyl) ketone such as bis(4-hydroxyphenyl) ketone or bis(3,5-dimethyl-4-hydroxyphenyl) ketone;

a biphenol such as biphenol, 3,3'-dimethylbiphenyl-4,4'-diol, 3,3'-di-tert-butylbiphenyl-4,4'-diol, or 3,3',5,5'-tetramethylbiphenyl-4,4'-diol; and

a bis(hydroxyphenyl) fluorene such as 9,9-bis(3-amino-4-hydroxyphenyl) fluorene, 9,9-bis(4-hydroxy-3-methylphenyl) fluorene, or 9,9-bis(4-hydroxyphenyl) fluorene.

Examples of a compound having two phenolic hydroxy groups and another hydroxy group include 2-[bis(4-hydroxyphenyl) methyl] benzyl alcohol.

Examples of a compound having three phenolic hydroxy groups include 2,6-bis[(2-hydroxy-5-methylphenyl) methyl]-4-methylphenol, 2,4,6-tris(3',5'-di-tert-butyl-4'-hydroxybenzyl) mesitylene, α,α,α'-tris(4-hydroxyphenyl)-1-ethyl-4-isopropylbenzene, 1,1,1-tris(4-hydroxyphenyl) ethane, and 4,4',4"-trihydroxytriphenylmethane.

Examples of a compound having four phenolic hydroxy groups include tetrakis(4-hydroxyphenyl) ethylene, 4,4',4",4'''-methanetetrayltetraphenol, 9,9-bis(3,4-dihydroxyphenyl) fluorene, 4,4',4",4'''-[(1-methylethylidene) di-4-cyclohexanyl-1-ylidene] tetrakisphenol, and 9,9-bis(3,4-dihydroxyphenyl) fluorene.

Examples of a multimer include a phenolic resin such as a resol type phenolic resin or a novolac type phenolic resin; a polyphenol polymer such as a polyhydroxystyrene polymer obtained by polymerizing hydroxystyrene (which may be o-, m-, or p-); and a polyphenol copolymer obtained by copolymerizing hydroxystyrene (which may be o-, m-, or p-) with another polymerizable compound such as styrene, such as a polyhydroxystyrene copolymer.

As the phenol compound (D), those exemplified above can be used singly or in combination of two or more thereof at any ratio. Among these, those having two or more phenolic hydroxy groups are preferably used. As the phenol compound (D), a compound having 2 to 4 phenolic hydroxy groups is preferable in that elongation at break of a cured product of the negative photosensitive resin composition is better, and a compound having 2 or 3 phenolic hydroxy groups is more preferable in that adhesion to a silicon substrate is excellent in addition to the better elongation at break. As the phenol compound (D), a compound having two phenolic hydroxy groups is preferably used from a viewpoint that dissolution contrast ($\gamma$ value) of the negative photosensitive resin composition is better.

An upper limit of the molecular weight of the phenol compound (D) is 1,000 or less, preferably 800 or less, more preferably 700 or less, and still more preferably 600 or less. A lower limit of the molecular weight of the phenol compound (D) is preferably 150 or more, more preferably 200 or more, and still more preferably 300 or more.

<<Other components>>

The negative photosensitive resin composition of the present disclosure can contain other components as long as the effect of the present disclosure technique is not impaired. As other components, known components that can be contained in the negative photosensitive resin composition can be used, and examples thereof include: conductive particles; an inorganic filler; an organic filler; a colorant; a wet dispersant; a thermal polymerization inhibitor; an ultraviolet absorber; a silane coupling agent; a plasticizer; a flame retardant; an antistatic agent; an antiaging agent; an antioxidant; an antimicrobial/antifungal agent; a surface conditioner such as a defoaming agent or a leveling agent; a thickener; an adhesion imparting agent; a thixotropy imparting agent; a mold release agent; a surface treatment agent; a dispersant; a dispersion aid; a surface modifier; a stabilizer; a phosphor; a solvent; a basic compound; a plastic resin; a polymer resin; an

elastomer; an organic binder; and an alkali-soluble resin such as a carboxyl group-containing resin.

<Basic compound>

The negative photosensitive resin composition preferably contains a basic compound from a viewpoint of improving resolution, stability of a coating film in a resting time from application of the photosensitive resin composition to exposure, and the like.

The basic compound is not particularly limited, and examples thereof include: an amine compound such as trimethylamine, diethylamine, triethylamine, di-n-propylamine, tri-n-propylamine, tri-n-pentylamine, tribenzylamine, diethanolamine, triethanolamine, n-hexylamine, n-heptylamine, n-octylamine, n-nonylamine, ethylenediamine, N,N,N',N'-tetramethylethylenediamine, tetramethylenediamine, hexamethylenediamine, 4,4'-diaminodiphenylmethane, 4,4'-diaminodiphenyl ether, 4,4'-diaminobenzophenone, or 4,4'-diaminodiphenylamine; an amide compound such as formamide, N-methylformamide, N,N-dimethylformamide, acetamide, N-methylacetamide, N,N-dimethylacetamide, propionamide, or benzamide; a lactam such as pyrrolidone or N-methylpyrrolidone; an urea compound such as methylurea, 1,1-dimethylurea, 1,3-dimethylurea, 1,1,3,3-tetramethylurea, or 1,3-diphenylurea; a nitrogen-containing heterocyclic compound such as imidazole, benzimidazole, 4-methylimidazole, 8-oxyquinoline, acridine, purine, pyrrolidine, piperidine, 2,4,6-tri(2-pyridyl)-S-triazine, piperazine, 1,4-dimethylpiperazine, 1,4-diazabicyclo [2.2.2] octane, or pyridine; and a morpholine compound such as morpholine or 4-methylmorpholine. These can be used singly or in combination of two or more thereof at any ratio.

<Surface conditioner>

The negative photosensitive resin composition of the present disclosure preferably uses a surface conditioner in order to improve a leveling property of the negative photosensitive resin composition. The surface conditioner is not particularly limited as long as the effect of the present disclosure technique is not impaired, and dimethylsiloxane having a polyether structure or a polyester structure in a main chain is preferably used. Specific examples of the dimethylsiloxane having a polyether structure in a main chain include FZ-2122 manufactured by Dow Corning Toray Co., Ltd. and BYK-333 manufactured by BYK Japan KK. Specific examples of the dimethylsiloxane having a polyester structure include BYK-310 and BYK-370 manufactured by BYK-Chemie. These can be used singly or in combination of two or more thereof at any ratio.

<<<Preparation of negative photosensitive resin composition>>>

The negative photosensitive resin composition of the present disclosure can be obtained by mixing any components including a basic compound and a surface conditioner in addition to the components of the polyhydroxyamide compound (A), the photoacid generator (B), the crosslinking agent (C), and the phenol compound (D). The components can be mixed under heating as necessary.

The content of the polyhydroxyamide compound (A) can be 50 to 80% by mass when the total mass of the solid content of the negative photosensitive resin composition is 100% by mass.

The content of the photoacid generator (B) can be 0.5 to 10% by mass, and is preferably 1 to 5% by mass when the total mass of the solid content of the negative photosensitive resin composition is 100% by mass.

The content of the crosslinking agent (C) can be 10 to 40% by mass when the total mass of the solid content of the negative photosensitive resin composition is 100% by mass. As for the content of the crosslinking agent (C), a ratio between the number of crosslinkable groups (for example, methoxymethyl groups or methylol groups) contained in the crosslinking agent (C) and the number of hydroxy groups contained in the negative photosensitive resin composition (methoxymethyl group and/or methylol group : hydroxy group) can be 100 : 100 to 200 : 100. By setting the ratio to such a ratio, it is possible to obtain a cured product having better elongation at break without impairing resolution of the negative photosensitive resin composition and insulation reliability of a cured product thereof.

The content of the phenol compound (D) can be 0.005 to 20% by mass when the total mass of the solid content of the negative photosensitive resin composition is 100% by mass. The content of the phenol compound (D) is 0.01 parts by mass or more and 30 parts by mass or less, preferably 0.1 parts by mass or more and 25 parts by mass or less, and more preferably 0.5 parts by mass or more and 15 parts by mass or less when the solid content of the polyhydroxyamide compound (A) is 100 parts by mass. A mass ratio between the content of the crosslinking agent (C) and the content of the phenol compound having two or more hydroxy groups (D) can be 40 : 0.1 to 40 : 30, and is preferably 40 : 0.5 to 40 : 25, and more preferably 40 : 0.5 to 40 : 15.

The contents of the polyhydroxyamide compound (A) and the phenol compound (D) can be adjusted such that a ratio between the number of crosslinkable groups (for example, methoxymethyl groups or methylol groups) contained in the crosslinking agent (C) and the number of hydroxy groups (total of the number of hydroxy groups of the polyhydroxyamide compound (A) and the number of hydroxy groups of the phenol compound (D)) contained in the negative photosensitive resin composition (the number of crosslinkable groups : the number of hydroxy groups) is 120 : 100 to 200 : 100. By setting the ratio to such a ratio, it is possible to obtain a cured product having better elongation at break without impairing dissolution contrast of the negative photosensitive resin composition.

The content of the basic compound can be 0.01 to 5% by mass, and is preferably 0.05 to 1% by mass when the total mass of the solid content of the negative photosensitive resin composition is 100% by mass.

The content of the surface conditioner can be 0.01 to 5% by mass when the total mass of the solid content of the negative photosensitive resin composition is 100% by mass.

<<<Method for manufacturing dry film>>>

A dry film of the present disclosure includes a substrate and a resin layer formed on the substrate using the negative photosensitive resin composition of the present disclosure. In order to protect the resin layer, a protective film may be further laminated on a surface of the resin layer.

The substrate is not particularly limited, and examples thereof include a metal foil such as a copper foil; and a film such as a polyimide film, a polyester film, or a polyethylene naphthalate (PEN) film.

The protective film is not particularly limited, but a polyethylene film, a polytetrafluoroethylene film, a polypropylene film, paper, or the like can be used. As the protective film, a film having a lower adhesive force between the protective film and the resin layer than an adhesive force between the substrate and the resin layer is preferably selected. In order to make the adhesive force between the protective film and the resin layer lower than the adhesive force between the substrate and the resin layer, a film obtained by subjecting a surface of the protective film to a peeling treatment can be used.

The thickness of the resin layer is not particularly limited, but may be 1 to 150 μm depending on an application. The resin layer can be obtained, for example, by applying the negative photosensitive resin composition onto a substrate, adjusting the thickness of the resin layer using a comma coater, a blade coater, a lip coater, a rod coater, a squeeze coater, a reverse coater, a transfer roll coater, a gravure coater, a spray coater, or the like, and drying the resin layer.

<<<Method for manufacturing cured product>>>

A cured product of the present disclosure is obtained by curing the negative photosensitive resin composition of the present disclosure or the resin layer of the dry film of the present disclosure. The cured product may be a patterned cured product. Examples of a method for manufacturing the patterned cured product include the following methods.

<<Dry coating film forming step>>

A dry coating film forming step is a step of applying the negative photosensitive resin composition of the present disclosure onto a substrate to form a coating film, and then drying the coating film. In the dry coating film forming step, it is also possible to form a dry coating film on a substrate by transferring the resin layer of the dry film onto the substrate.

A method for applying the negative photosensitive resin composition onto a substrate is not particularly limited, and examples thereof include a method for applying the negative photosensitive resin composition using a spin coater, a bar coater, a blade coater, a curtain coater, a screen printer, or the like, a method for spray-applying the negative photosensitive resin composition with a spray coater, and an inkjet method. A coating film thickness is not particularly limited, and can be, for example, 10 μm or less, 5 μm or less, or 3 μm or less.

A method for drying the coating film is not particularly limited, and examples thereof include air drying, heat drying with an oven or a hot plate, and vacuum drying. Conditions for performing heat drying are, for example, a heating temperature of 70 to 140°C and a drying time of 1 to 30 minutes.

The transfer of the resin layer of the dry film onto the substrate is preferably performed under pressure and heating using a vacuum laminator or the like. A heating temperature can be, for example, 60 to 100°C.

The substrate is not particularly limited, and can be, for example, a printed wiring board on which a circuit is formed, a flexible printed wiring board, or a wafer on which a semiconductor element is formed.

<<Exposure step>>

An exposure step is a step of irradiating the dry coating film formed in the dry coating film forming step with a radiation via a photomask capable of forming a desired pattern, thereby exposing the photoacid generator (B) in an exposed portion to light and generating an active species. When patterning is not necessary, it is not necessary to use a photomask. In addition, a pattern may be directly drawn with a laser using a direct drawing apparatus.

As a wavelength of the radiation, a radiation having a wavelength at which the photoacid generator (B) can be

activated is used, and in order to perform miniaturized patterning, a radiation having a maximum wavelength of 410 nm or less is preferable. Irradiation energy can be adjusted by the thickness of the formed dry coating film or the like, and can be, for example, 10 to 1000 mJ/$cm^2$. As an exposure light source, a high-pressure mercury lamp, an ultra-high-pressure mercury lamp, a metal halide lamp, a mercury short arc lamp, a KRF laser, or the like can be used.

<<PEB step>>

A PEB step is a step of heat-treating the dry coating film exposed in the exposure step to impart development resistance to an exposed portion of the dry coating film (hereinafter, also abbreviated as an exposed portion). In the PEB step, a crosslinking reaction between the polyhydroxyamide compound (A) or the phenol compound (D) and the crosslinking agent (C) proceeds using an acid generated from the photoacid generator (B) as an active species in the exposed portion, and the exposed portion is insolubilized in a developer. A heating temperature in the PEB step can be 90 to 150°C and a heating time can be 0.5 to 10 minutes. Heating can be performed by a known method such as a hot plate or a heating furnace.

<<Development step>>

The development step is a step of obtaining a pattern coating film by treating the dry coating film heated in the PEB step with a developer and dissolving and removing an unexposed portion of the dry coating film in the developer. As a developing method, a known method can be used, and examples thereof include a rotation spraying method, a paddle method, and an immersion method with an ultrasonic treatment.

As the developer, a known developer can be used, and examples thereof include aqueous solutions of an inorganic alkali such as sodium hydroxide, sodium carbonate, sodium silicate, or ammonia water, an organic amine such as ethylamine, diethylamine, triethylamine, or triethanolamine, and a quaternary ammonium salt such as tetramethylammonium hydroxide or tetrabutylammonium hydroxide. A water-soluble organic solvent such as methanol, ethanol, or isopropyl alcohol or a surfactant can be added as necessary.

After the treatment with the developer, the coating film can be washed with a rinse solution as necessary to obtain a pattern coating film. The rinse solution is not particularly limited, and examples thereof include pure water, methanol, ethanol, and isopropyl alcohol. These can be used singly or in combination of two or more thereof at any ratio.

<<Post-development heating step>>

A method for manufacturing a cured product can include a post-development heating step as necessary. The post-development heating step is a step of heating the pattern coating film formed in the development step to complete curing of the pattern coating film to obtain a cured pattern coating film (cured product). A heating temperature can be 150 to 200°C, and a heating time can be 1 to 120 minutes. Heating can be performed by a known method such as a hot plate or an inert oven, and is desirably performed in a nitrogen atmosphere.

<<<Application of negative photosensitive resin composition>>>

The negative photosensitive resin composition of the present disclosure can be suitably used as a material for forming a display device, a semiconductor element, an electronic component, an optical component, a building material, or the like. A material for forming a semiconductor element is, for example, a resist material, a buffer coat film, or an insulating film for a rewiring layer of a wafer level package (WLP). The negative photosensitive resin composition can be preferably used particularly in a rewiring layer forming step using a damascene method. Examples of a material for forming an electronic component include a printed wiring board, an interlayer insulating film, and a wiring coating film.

Examples

The present disclosure technique will be described in more detail with reference to Examples, but the present disclosure technique is not limited to Examples.

<<Raw materials of negative photosensitive resin composition>>

<(A) Polyhydroxyamide compound>

(Synthesis Example 1: Synthesis Example A-1 of polyhydroxyamide compound)

In a 500 mL flask equipped with a stirrer and a thermometer, 14.93 g (44.39 mmol) of 2,2-bis(3-amino-4-hydroxyphenyl) hexafluoropropane (6FAP) and 2.45 g (22.42 mmol) of 3-aminophenol were stirred and dissolved in 79 g of N-methylpyrrolidone (NMP). Thereafter, the flask was immersed in an ice bath, and while the inside of the flask was maintained at 0 to 5°C, 16.41 g (55.61 mmol) of 4,4'-oxybis(benzoyl chloride) (DEDC) was added as a solid thereto over 10 minutes, and the mixture was stirred in the ice bath for 30 minutes. After being stirred at room temperature for 18 hours, the solution was put into a large amount of deionized water, and a precipitate was collected. The obtained solid was dissolved in 79 g of ethyl acetate. To the solution, 17 g of an anion exchange resin (Amberlyst B-20 manufactured by ORGANO CORPORATION) was added, and the mixture was vigorously stirred for one hour. The stirred solution was concentrated and then put into a large amount of deionized water, and a precipitate was collected. The precipitated solid was collected and then dried under reduced pressure to obtain a polyhydroxyamide compound (A-1) having a hydroxy group terminal.

The obtained polyhydroxyamide compound (A-1) had a weight average molecular weight (Mw) of 9,200, a number average molecular weight (Mn) of 3,600, a molecular weight dispersion degree (PDI) of 2.6, and a hydroxy group equivalent of 252 g/eq.

(A-1) Polyhydroxyamide compound

[Chemical Formula 4]

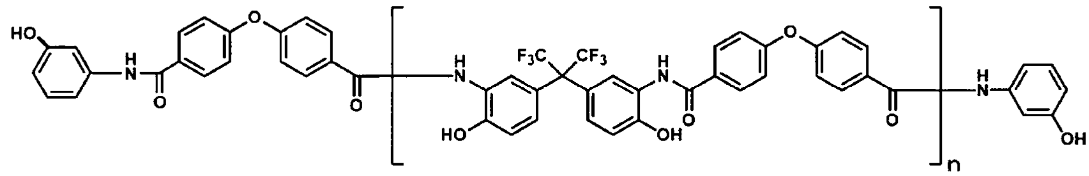

<(B) Photoacid generator>

(B-1) PAG-103 (oxime sulfonate compound manufactured by BASF SE)

[Chemical Formula 5]

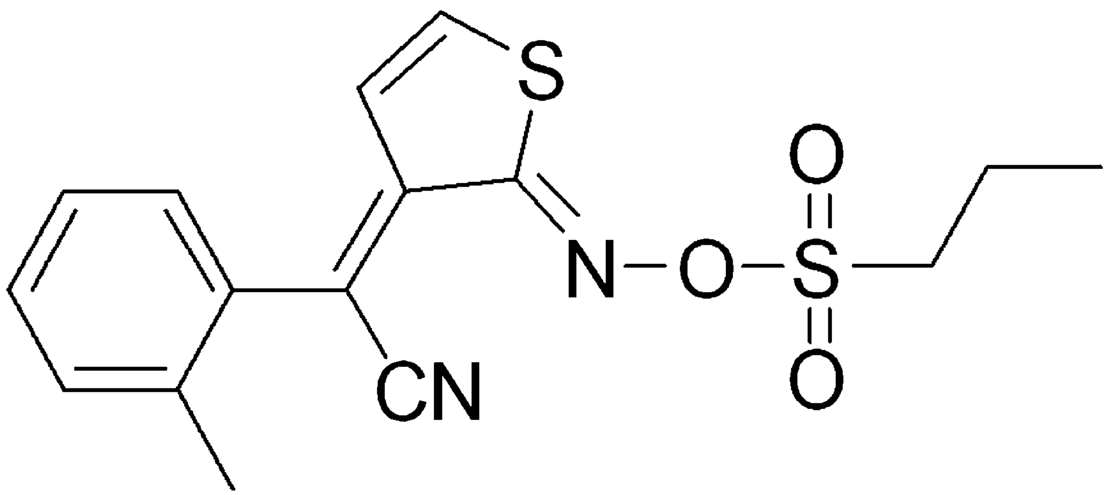

<(C) Crosslinking agent>

(C-1) MW-390 (hexamethoxymethylmelamine compound manufactured by Nippon Carbide Industries Co., Ltd.)

[Chemical Formula 6]

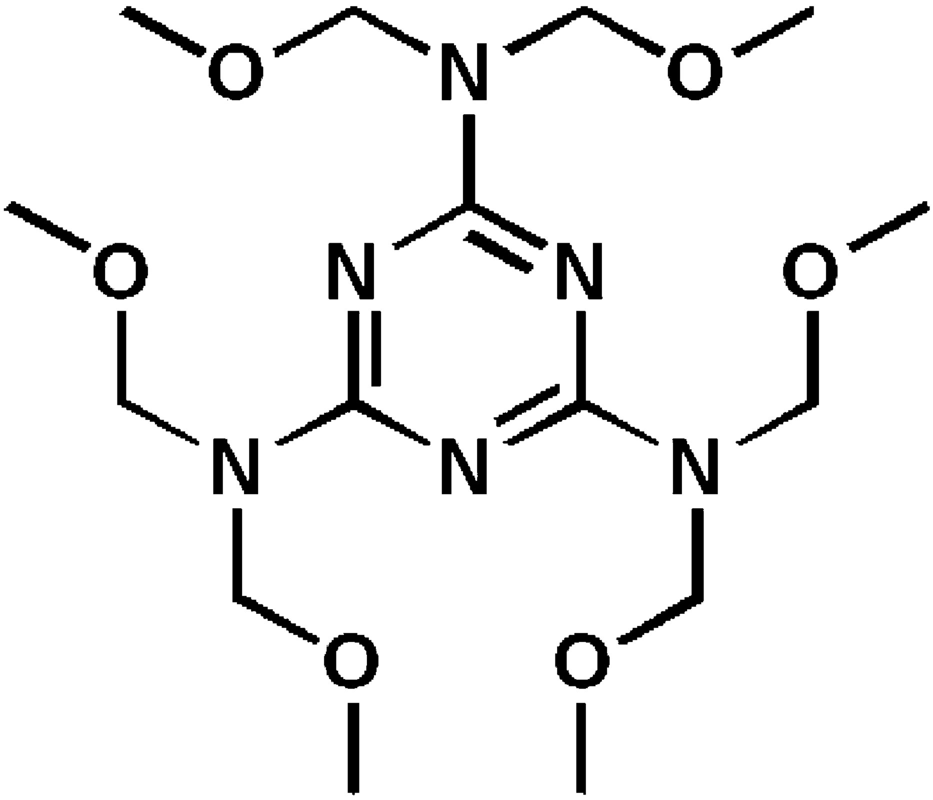

<(D) Phenol compound having two or more hydroxy groups>

(D-1) 9,9-bis(4-hydroxyphenyl) fluorene (BPF, molecular weight: 350.4)

[Chemical Formula 7]

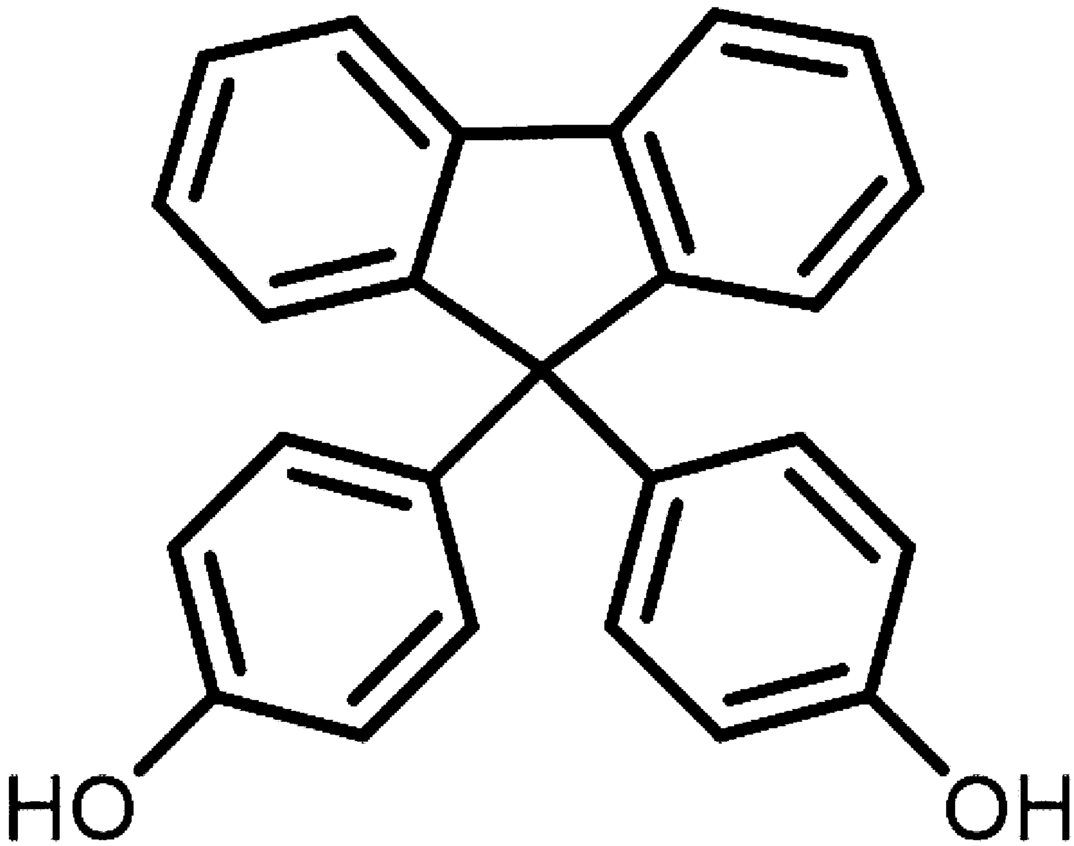

(D-2) α,α,α'-tris(4-hydroxyphenyl)-1-ethyl-4-isopropylbenzene (THP, molecular weight: 424.5)

[Chemical Formula 8]

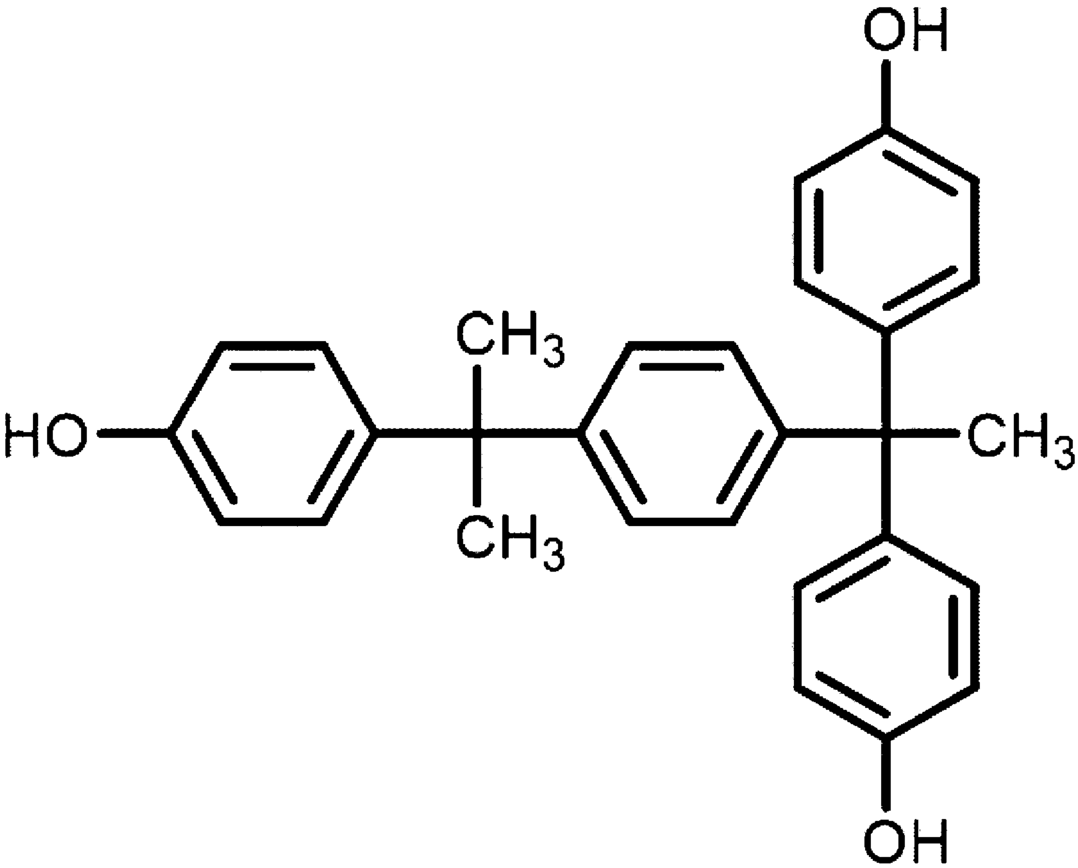

(D-3) 4,4',4",4"'-[(1-methylethylidene) di-4-cyclohexanyl-1-ylidene] tetrakisphenol, 9,9-bis(3,4-dihydroxyphenyl) fluorene (TekP-4HBPA, molecular weight: 576.8)

[Chemical Formula 9]

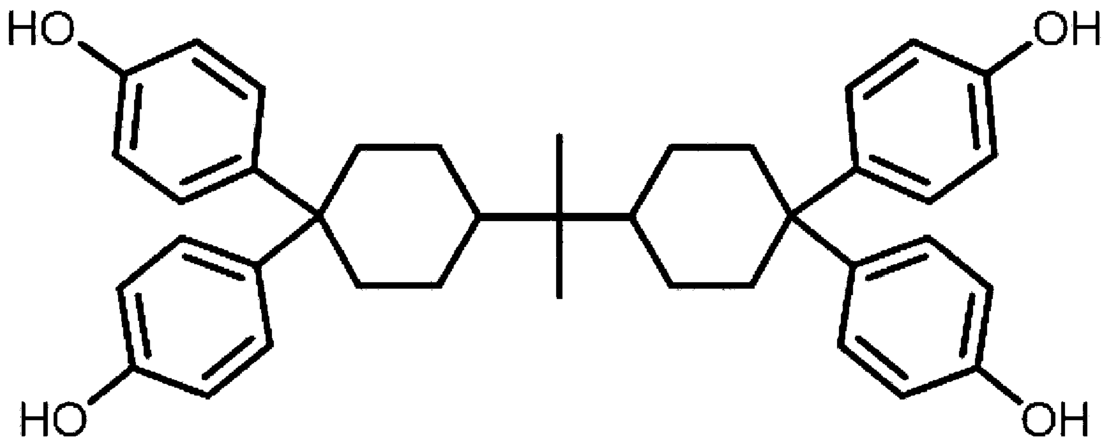

(D-4) VPS-2515 (polyhydroxystyrene-styrene copolymer manufactured by Nippon Soda Co., Ltd., $n_1 : n_2$ = 85 : 15, molecular weight (weight average molecular weight): 4,100, hydroxy group equivalent: 140 g/eq)

[Chemical Formula 10]

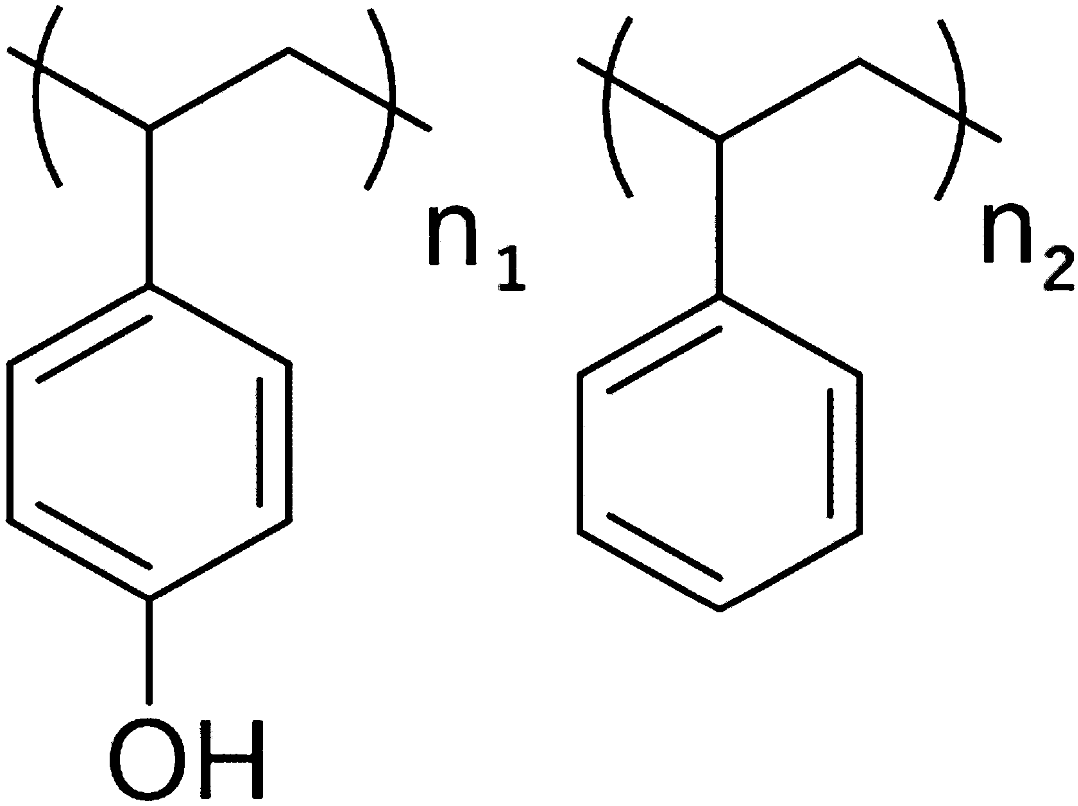

<Basic compound>

(E-1) Triethanolamine (TEA)

<Surface conditioner>

(F-1) BYK-310 (silicone-based surface conditioner manufactured by BYK Japan KK)

<<Preparation of negative photosensitive resin composition>>

Components were blended in the amounts (parts by mass) presented in Table 1, and dissolved and adjusted with cyclopentanone such that a concentration of a nonvolatile component in a varnish was 30% to obtain each of varnishes of negative photosensitive resin compositions of Examples and Comparative Examples. In addition, an equivalent ratio between a crosslinkable group of a crosslinking agent and a hydroxyl group (the total number of hydroxyl groups of a polyhydroxyamide compound and a phenol compound) in the composition ($NCH_2OCH_3$ group : OH group) calculated from blending amounts of the raw materials of the negative photosensitive resin composition is presented in Table 1.

<<Evaluation>>

Using the obtained varnishes of Examples and Comparative Examples, the following evaluations were performed. Evaluation results are presented in Table 1.

<Evaluation of dissolution contrast (measurement of $\gamma$ value)>

Each of the obtained varnishes of Examples and Comparative Examples was applied onto a silicon wafer using a spin coater such that the thickness thereof after curing was 3.0 μm, and soft-baked on a hot plate at 90°C for 180 seconds to obtain each of dry coating films of Examples and Comparative Examples. The obtained dry coating film was subjected to

surface exposure using UV light (wavelength: 365 nm) while an exposure amount was changed by 10.0 $mJ/cm^2$ in a range of 0 to 100.0 mJ, and further heated at 120°C for 60 seconds. Thereafter, the dry coating film was developed with a 2.38% tetramethylammonium hydroxide (TMAH) aqueous solution (developer) for 30 seconds and rinsed with pure water, a residual film ratio at each exposure amount was measured, and a semi-logarithmic graph with the vertical axis representing a residual film ratio, the horizontal axis representing an exposure amount, and the horizontal axis representing a logarithmic axis was created to obtain a sensitivity curve. In this sensitivity curve, an approximate straight line was calculated in a range from a rising point of the sensitivity curve to a data point where the residual film ratio was about 70% and the exposure amount was the smallest, and dissolution contrast (γ value) was calculated from a slope of the approximate straight line. Results of Examples and Comparative Examples are presented in Table 1.

<Evaluation of Young's modulus, breaking strength, and elongation at break>

Each of the varnishes of Examples and Comparative Examples was applied onto a silicon substrate using a spin coater such that the thickness thereof after curing was 10 μm, and soft-baked on a hot plate at 90°C for 180 seconds to obtain each of dry coating films of Examples and Comparative Examples. The obtained dry coating film was subjected to surface exposure using UV light (wavelength: 365 nm) such that an exposure amount was 300 mJ, and further heated and dried in an inert oven at 220°C for one hour to obtain a cured film. The obtained cured film was subjected to a pressure cooker (PCT) test (conditions: a treatment for one hour under conditions of a temperature of 121°C and a humidity of 100%), peeled from the substrate, and then formed into a strip shape of 70 mm in length × 5 mm in width, and subjected to a tensile test under the following conditions using a small desktop testing machine (EZ-SX manufactured by Shimadzu Corporation).

Young's modulus was calculated from a slope of a stress-strain curve obtained from the tensile test, breaking strength was calculated from a stress when a sample was broken in the tensile test, and elongation at break was calculated from the following calculation formula as elongation until a sample was broken in the tensile test. A measured value of Young's modulus, a measured value of breaking strength, and a measured value of elongation at break were each an average value of measured values obtained by performing five similar tensile tests. Results thereof are presented in Table 1.

[Measurement conditions]

Tester: Tensile tester EZ-SX (manufactured by Shimadzu Corporation)
Distance between chucks: 50 mm
Test speed: 1 mm/min
Elongation calculation: (tensile movement amount/distance between chucks) × 100

<Evaluation of adhesion (cross-cut test)>

<Adhesion>

Each of the obtained varnishes was applied onto a silicon substrate using a spin coater such that the thickness thereof after curing was 10 μm, and soft-baked on a hot plate at 90°C for 180 seconds to obtain each of dry coating films of Examples and Comparative Examples. The obtained dry coating film was subjected to surface exposure using UV light (wavelength: 365 nm) such that an exposure amount was 300.0 mJ, and further heated and dried in an inert oven at 220°C for one hour to obtain a silicon substrate having a cured film on a surface thereof. On the obtained dry coating film, squares of 1 × 1 (mm) size were formed with a cutter knife such that 100 squares with ten rows and ten columns were formed in total, and the squares were then peeled off with a tape. Adhesion was evaluated by counting the number of squares peeled off from the silicon substrate. Among the square cured films, the number of cured films remaining on the silicon substrate is presented as a result (the number of remaining cured films/100) in Table 1.

[Table 1]

| Item | | | Example | | | | | | | | | Comparative Example | | |
|---|---|---|---|---|---|---|---|---|---|---|---|---|---|---|
| | | | 1 | 2 | 3 | 4 | 5 | 6 | 7 | 8 | 9 | 1 | 2 | 3 |
| Polyhydroxyamide compound (A) | A-1 | 6FAP-DEDC-3AP | 100 | 100 | 100 | 100 | 100 | 100 | 100 | 100 | 100 | 100 | 100 | 100 |
| Photoacid generator (B) | B-1 | PAG103 | 5 | 5 | 5 | 5 | 5 | 5 | 5 | 5 | 5 | 5 | 5 | 5 |
| Crosslinking agent (C) | C-1 | HMM | 40 | 40 | 40 | 40 | 40 | 40 | 40 | 40 | 40 | 40 | 40 | 40 |
| Phenol compound (D) | D-1 | BPF | 5 | 10 | 20 | | | | | | | | | |
| | D-2 | THP | | | | 5 | 10 | 20 | | | | | | 40 |
| | D-3 | TekP-4-HBPA | | | | | | | 5 | 10 | 20 | | | |
| | D-4 | VPS-2515 | | | | | | | | | | | 5 | |
| Basic compound | E-1 | TEA | 0.15 | 0.15 | 0.15 | 0.15 | 0.15 | 0.15 | 0.15 | 0.15 | 0.15 | 0.15 | 0.15 | 0.15 |
| Surface conditioner | F-1 | BYK-310 | 0.12 | 0.12 | 0.12 | 0.12 | 0.12 | 0.12 | 0.12 | 0.12 | 0.12 | 0.12 | 0.12 | 0.12 |
| Functional group equivalent | Crosslinkable group $NCH_2OMe$: OH | | 168:100 | 155:100 | 135:100 | 164:100 | 150:100 | 127:100 | 164:100 | 151:100 | 128:100 | 181:100 | 162:100 | 99:100 |
| Lithography evaluation Process conditions | Film thickness [um] | | 3.0 | 3.0 | 3.0 | 3.0 | 3.0 | 3.0 | 3.0 | 3.0 | 3.0 | 3.0 | 3.0 | 3.0 |
| | Softbake [°C/s] | | 90/180 | 90/180 | 90/180 | 90/180 | 90/180 | 90/180 | 90/180 | 90/180 | 90/180 | 90/180 | 90/180 | 90/180 |
| | Exposure amount [$mJ/cm^2$] | | 100 | 100 | 100 | 100 | 100 | 100 | 100 | 100 | 100 | 100 | 100 | 100 |
| | PEB [°C/s] | | 120/60 | 120/60 | 120/60 | 120/60 | 120/60 | 120/60 | 120/60 | 120/60 | 120/60 | 120/60 | 120/60 | 120/60 |
| | Development time [s] | | 30 | 30 | 30 | 30 | 30 | 30 | 30 | 30 | 30 | 30 | 30 | 30 |
| Dissolution contrast | $\gamma$ | | 10.6 | 14.7 | 15.3 | 4.5 | 4.9 | 5.1 | 7.8 | 4.3 | 4.4 | 4.8 | 6.1 | 6.0 |
| Young's modulus | GPa | | 3.2 | 3.3 | 3.5 | 3.3 | 2.5 | 3.0 | 3.7 | 3.4 | 3.2 | 3.6 | 3.5 | 3.7 |

(continued)

| Item | | Example | | | | | | | | | Comparative Example | | |
|---|---|---|---|---|---|---|---|---|---|---|---|---|---|
| | | 1 | 2 | 3 | 4 | 5 | 6 | 7 | 8 | 9 | 1 | 2 | 3 |
| Breaking strength | MPa | 107 | 112 | 117 | 110 | 85 | 93 | 121 | 119 | 108 | 111 | 73 | 103 |
| Elongation at break | % | 5.9 | 6.3 | 5.8 | 6.6 | 6.2 | 5.1 | 5.6 | 5.3 | 4.9 | 3.5 | 2.1 | 3.3 |
| Cross-cut test | Number of remaining cured films/100 | 97/100 | 100/100 | 100/100 | 99/100 | 95/100 | 100/100 | 18/100 | 45/100 | 100/100 | 1/100 | 1/100 | 100/100 |

## Claims

1. A negative photosensitive resin composition comprising: a polyhydroxyamide compound (A); a photoacid generator (B); a crosslinking agent (C); and a phenol compound having two or more hydroxy groups (D), wherein

    the phenol compound having two or more hydroxy groups (D) has a molecular weight of 1,000 or less, and
    a content of the phenol compound having two or more hydroxy groups (D) is 0.01 parts by mass or more and 30 parts by mass or less with respect to 100 parts by mass of a solid content of the polyhydroxyamide compound (A).

2. The negative photosensitive resin composition according to claim 1, wherein a mass ratio between a content of the crosslinking agent (C) and a content of the phenol compound having two or more hydroxy groups (D) is the crosslinking agent (C) : the phenol compound having two or more hydroxy groups (D) = 40 : 0.1 to 40 : 30.

3. A dry film comprising a resin layer formed of the negative photosensitive resin composition according to claim 1.

4. A cured product obtained by curing the negative photosensitive resin composition according to claim 1 or 2 or the resin layer of the dry film according to claim 3.

5. An electronic component comprising the cured product according to claim 4.

## INTERNATIONAL SEARCH REPORT

International application No. **PCT/JP2024/013181**

### A. CLASSIFICATION OF SUBJECT MATTER

***G03F 7/038***(2006.01)i; ***C08G 69/02***(2006.01)i; ***G03F 7/004***(2006.01)i
FI: G03F7/038 601; G03F7/004 512; C08G69/02

According to International Patent Classification (IPC) or to both national classification and IPC

### B. FIELDS SEARCHED

Minimum documentation searched (classification system followed by classification symbols)

G03F7/038; C08G69/02; G03F7/004

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | WO 2020/026937 A1 (TORAY INDUSTRIES, INC.) 06 February 2020 (2020-02-06) claims, examples | 1-5 |
| X | WO 2022/064917 A1 (FUJIFILM CORPORATION) 31 March 2022 (2022-03-31) claims, examples, paragraphs [0196], [0354] | 1-5 |
| X | JP 2005-250161 A (KYOCERA CHEMICAL CORP.) 15 September 2005 (2005-09-15) claims, examples | 1-5 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **03 June 2024** | **18 June 2024** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (July 2022)

**INTERNATIONAL SEARCH REPORT**
**Information on patent family members**

International application No.
**PCT/JP2024/013181**

| Patent document cited in search report | Publication date (day/month/year) | Patent family member(s) | Publication date (day/month/year) |
|---|---|---|---|
| WO 2020/026937 A1 | 06 February 2020 | US 2021/0116810 A1<br>claims, examples<br>CN 112424289 A<br>KR 10-2021-0036908 A<br>TW 202018013 A | |
| WO 2022/064917 A1 | 31 March 2022 | KR 10-2023-0043155 A<br>CN 115989457 A<br>TW 202212992 A | |
| JP 2005-250161 A | 15 September 2005 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2001125267 A
- WO 2012172793 A